# EUROPEAN PATENT SPECIFICATION

(11) **EP 3 959 754 B1**
(45) Date of publication and mention of the grant of the patent: **25.12.2024**
(21) Application number: 20814433.7
(22) Date of filing: 28.05.2020
(51) Int. Cl.: H02S 40/34, H02S 40/36, H02S 20/23

(54) **HOMOGENEOUS TRANSPARENT COATED GREENHOUSE ELECTRICAL GENERATING DEVICES, AND INTERNAL AND EXTERNAL ELECTRICAL INTERCONNECTIONS**
HOMOGENE TRANSPARENTE, BESCHICHTETE GEWÄCHSHAUSARTIGE STROMGENERATOREN SOWIE INTERNE UND EXTERNE ELEKTRISCHE VERBINDUNGEN
DISPOSITIFS DE PRODUCTION D'ÉLECTRICITÉ DE TYPE SERRE À REVÊTEMENT TRANSPARENT HOMOGÈNE, ET INTERCONNEXIONS ÉLECTRIQUES INTERNES ET EXTERNES

(30) Priority: 29.05.2019 US 201962854276 P; 22.10.2019 US 201916660388
(43) Date of publication of application: 02.03.2022
(73) Proprietor: SolarWindow Technologies, Inc., Scottsdale, AZ 85260 (US)
(72) Inventor: CONKLIN, John, Anthony, Apalachin, NY 13732 (US); SARGENT, Patrick, T., Canton, GA 30114 (US)
(74) Representative: Murgitroyd & Company
(86) International application number: PCT/US2020/034845
(87) International publication number: WO 2020/243251

(56) References cited:
- WO-A1-2010/014941
- US-A1- 2005 161 080
- US-A1- 2010 116 325
- US-A1- 2011 114 149
- US-A1- 2016 013 433
- US-A1- 2016 013 433
- US-A1- 2016 226 434
- US-A1- 2017 194 900
- US-A1- 2019 089 294
- US-B1- 6 369 315
- US-B2- 8 418 401

## Description

### FIELD OF THE INVENTION

The present invention is directed to a system for collecting electrical energy produced by a homogeneous transparent electricity-generating glass or plastic devices (TEGD) in greenhouse environments, and more particularly, to a system for a greenhouse including a homogeneous transparent electricity-generating glass or plastic devices (TEGD) and an associated internal electrical module junction box transfer device (E-JBTD), and more particularly, to a greenhouse including a system having a homogeneous transparent electricity-generating glass or plastic devices (TEGD) and an associated internal electrical module junction box transfer device (E-JBTD).

### BACKGROUND

Modern commercial greenhouses (aka glasshouse or a hothouse) are becoming increasingly technologically advanced buildings that are desirably capable of operating in ever-increasing efficient manners. The modern greenhouse demands energy efficiency and reduced energy consumption to produce in-demand products. A typical greenhouse is a structure with walls and roof made chiefly of transparent material, such as glass or plastic, in which plants requiring regulated climatic conditions are grown. These greenhouse structures range in size from small sheds to industrial-sized buildings occupying acres of space.

A typical greenhouse utilizing conventional mono- or poly-crystalline silicon, thin-film, etc. may include Solar Photovoltaic (PV) modules that are either ground-mounted or placed on rack systems mounted directly to the frame, which may shade natural light required for optimum plant or vegetable growth. The current conventional non-transparent black body electricity generating PV module, while being capable of manufacturing electricity may not be capable of permitting enough light to pass into the greenhouse to enable electricity generation and plant growth at the same time. The typical PV module is not designed to let required light for plant growth to move through the module, but instead, is designed to block almost all light, thereby allowing for electricity generation only.

US 2019/089294 A1 describes module connectors for flexible photovoltaic modules.

US 2016/013433 A1 describes the application of transparent organic solar cells in a greenhouse, which includes an enclosing structure including transparent organic photo-voltaic cell being that is at least 10% transparent to sun light.

### SUMMARY OF THE INVENTION

The present invention provides a system according to claim 1 and a greenhouse electricity-generating system comprising an organic photovoltaic homogeneous coated electrical generating laminated device as defined in the appended claims

The present invention recognizes that it is desirable that greenhouses permit as much visible light as possible to pass completely through an electricity-generating device, such as an electricity-generating device that replaces typical greenhouse glass or plastic materials, so that the electricity-generating device appears as either transparent, or mostly transparent with only a moderate visible tint. The present invention further recognizes that transparent or semitransparent organic photovoltaic devices may be innocuously used in conjunction with greenhouse glass or plastic windows to avoid installation of light blocking traditional photovoltaic greenhouse frame mounted array systems.

For the reasons stated above and for other reasons stated below which will become apparent to those skilled in the art upon reading and understanding the specification, there is a need in the art for transparent organic photovoltaic greenhouse structures and devices.

The embodiments of the present invention provide methods and systems for transparent organic photovoltaic devices and will be understood by reading and studying the following specification.

The present invention also recognizes that the discrete points of contacts or connections in conventional electrical wiring connection systems present challenges for the installation of homogeneous transparent electricity-generating glass or plastic devices (TEGD) that have limited or constrained access by space or location. The present invention also recognizes that current greenhouse framing systems present a challenge in safely securing transparent electricity-generating glass or plastic devices (TEGD) to typical greenhouse structures, while at the same time allowing for easy unimpaired wiring configurations.

In the conventional art, the installation of a homogeneous transparent electricity-generating glass or plastic device (TEGD) and associated with the use of a conventional electrical J-Box device may be compromised or prohibited by difficult, if not impossible, installations due to space, fixture, building and mounting constraints that do not allow proper or secure module mounting, or electrical connection.

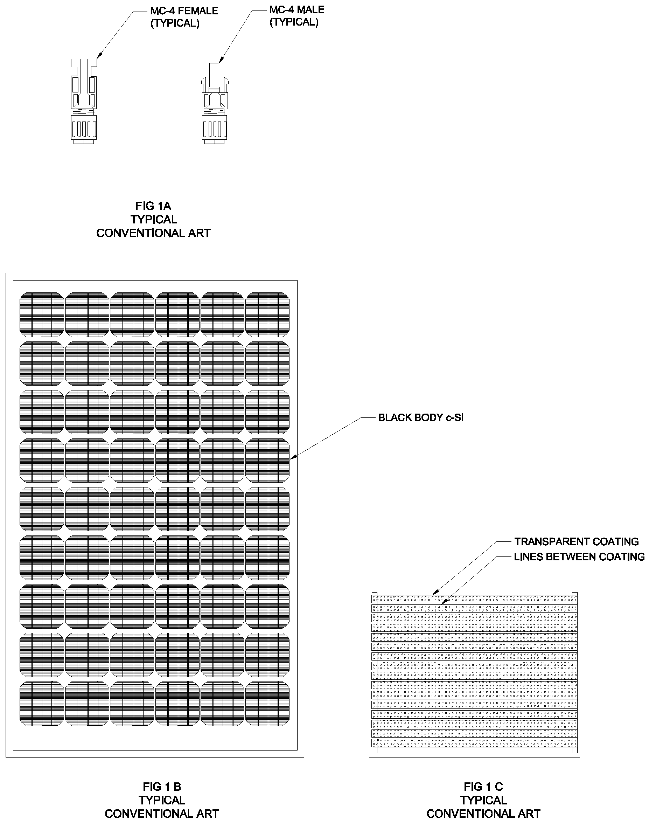

As shown for example in FIGS. 1B and 1C, the current conventional art renewable products and devices are not configured to permit, and are not capable of permitting, even, required light to pass through the module into the greenhouse in order to allow for plant growth, while at the same time providing ample amounts of electricity generation simultaneously by the same device. For example, as illustrated in FIG. 1C, conventional or transparent photovoltaic (PV) devices, bi-facial lane coated modules, and amorphous silica type PV modules have lines of uncoated glass or plastic that has visually and light distorting lines and semitransparent wide coated lines that may interfere with, obstruct, or limit light transmission through the coatings into the interior of the greenhouse, thereby resulting in blocked light transmission into the greenhouse and onto plants within the greenhouse, which may have a detrimental negative effect on the growing of such plants.

Moreover, as illustrated in FIG. 1B, the current art of non-transparent c-Si (Black Body) photovoltaic (PV) modules will only allow a small portion of light to pass through the module, between the black body semiconductors which results in the plants receiving very limited, insufficient amounts of light for proper or desired plant growth.

In addition, in conventional PV interconnected systems and arrangements, the associated electrical J-Box is mounted to the back of a module attached to the back of drilled glass or plastic and is oriented in such a way that the system, or parts thereof, cast undesirable shadows on surfaces within the greenhouse. The conventional systems and arrangements also may suffer from improper wire management allowing for flawed aesthetics and imperfections and further affecting light transmission, shadows, etc.

The present invention recognizes that there is a need for this art in the industry for replacing passive uncoated glass or plastic systems and conventional PV electricity-generating devices and associated J-Box electrical connections with improved homogeneous transparent electricity-generating devices (TEGD) and associated and simplified internal- and external-connection systems for collecting the electrical energy produced by the homogeneous transparent electricity-generating glass or plastic devices (TEGD), in greenhouse environments.

To solve these and other related mounting, light transmittance and electrical connection issues, the present invention provides a system including a novel homogeneous transparent electricity-generating device and associated internal electrical module junction box transfer device (E-JBTD) that reduces costs, increases needed light, improves efficiency, safety and electrical connectivity, and improves and simplifies the installation process, thereby providing important advantages for electricity production for homogeneous transparent electricity-generating glass or plastic devices (TEGD) needed by the modern efficient greenhouse.

The present invention further provides a novel homogeneously, uniform, applied Organic Photovoltaic (OPV) coating that is even across the whole expanse of the entire, edge-to-edge, surface of the glass or plastic, allowing for even light transmittance. The OPV coating allowing even light across the entire module comes in various colors and visual light transmittance (VLT) levels. The ability in modifying color and VLT will allow the greenhouse to be specifically designed in the most efficient way based upon the product being grown. The present invention also provides an internal electrical module junction box transfer device (E-JBTD) that allows homogeneous transparent electricity-generating glass or plastic devices (TEGD) to maintain connection tightness, structural integrity, function, and purpose of a module, laminated veneer, etc., and all other glass or plastic fabricated products and devices, to function as designed and fabricated while allowing effective electricity transfer from the electricity-generating surface(s) or coatings of the transparent electricity-generating glass or plastic devices (TEGD) to the internal and external elements of the electrical module junction box transfer device (E-JBTD). The exemplary embodiments of the invention allow for maximum light transmittance, and efficient electricity transfer using homogeneous transparent electricity-generating glass or plastic devices (TEGD), while at the same time maintaining all of the performance properties regarding light transfer, electricity and power generation, and required plant growth.

The present invention further recognizes that the combining of an exemplary homogeneous coated transparent electricity-generating glass or plastic device (TEGD) and an electrical module junction box transfer device (E-JBTD) will allow productive, efficient, and effective electricity transfer from the device for use in a greenhouse environment. According to example embodiments of the invention, an electrical module junction box transfer device (E-JBTD) can be configured as an integral part of any electricity-generating glass or plastic (EGP) or homogeneous transparent electricity-generating glass or plastic device (TEGD) module. It is desirable, and in some cases critical, that electron transfer from the electrical coating and/or connections on the inside of the electricity-generating glass or plastic devices (TEGD) be safely, efficiently, and/or effectively interconnected to the external frame mounted wiring systems for electricity transfer.

The homogeneous electricity-generating glass or plastic device (TEGD) and the electrical module junction box transfer device (E-JBTD) can include engagement devices at opposite electrical series or parallel string terminal connections configured to maximize voltage and current for effective power levels needed for proper connection to other balance of systems (BOS) components.

The homogeneous electricity-generating glass or plastic device (TEGD) and the electrical module junction box transfer device (E-JBTD) can be integrated into a typical double lite laminated glass or plastic product or device. In some examples, the OPV electricity-generating coating can be evenly applied to the second surface of the first low iron lite, laminated utilizing typical lamination films, and sandwiched between the second lite of low iron glass or plastic. The electricity-generating OPV coating is novel in inception and the connecting of the coating and the electrical module junction box transfer device (E-JBTD) can include one or more rigidly mounted in place electrical connector(s), which are physically separated by a non-conductive dielectric insulating material protecting and insulating the electrical contacts. The interconnection between the module and electrical module junction box transfer device (E-JBTD) is also novel in inception, and the completion of the connection is utilized by pressing the electrical module junction box transfer device (E-JBTD) on to the existing OPV module electrical tabs and firmly seating the electrical module junction box transfer device (E-JBTD) on the bottom of the homogeneous electricity-generating glass or plastic device (TEGD). The internal electrical connections are then translated to typical or standardized MC-4 connections, similar to common conventional electrical connections shown, for example, in FIG. 1A. The MC-4 connections are single-contact electrical connectors commonly used for connecting solar panels and the typical industry standard with regard to module-to-module, or module-to-balance of systems (BOS) terminal wire connections.

An exemplary embodiment of the invention is directed to a homogeneous electricity-generating glass or plastic device (TEGD) and associated electrical module junction box transfer device (E-JBTD) for a transparent greenhouse electrical generating module. The homogeneous electricity-generating device (TEGD) including two or more low iron glass or plastic lites, a homogeneous applied OPV coating, and lamination film, and an electrical module junction box transfer device (E-JBTD) including one or more electrical connectors, and a non-conductive dielectric insulating material protecting the one or more electrical connectors. The homogeneous electricity-generating glass or plastic device (TEGD) and an electrical module junction box transfer device (E-JBTD) can include one or more single-contact electrical connectors electrically connected to the one or more electrical connectors. The one or more single-contact electrical connectors can include MC-4 connections.

Other features and advantages of the present invention will become apparent to those skilled in the art upon review of the following detailed description and drawings.

### BRIEF DESCRIPTION OF THE DRAWINGS

These and other aspects and features embodiments of the present invention will be better understood after reading the following detailed description, together with the attached drawings, contained herein:
FIG. 1A illustrates an example of a conventional male and female MC-4 connector of a photovoltaic (PV) module;
FIG. 1B illustrates an example of a conventional bi-facial photovoltaic (PV) module;
FIG. 1C illustrates an example of a conventional transparent photovoltaic (PV) module;
FIG. 2A illustrates a schematic side view of an electrical module junction box transfer device (E-JBTD) according to an exemplary embodiment of the invention;
FIG. 2B illustrates a schematic top view of an electrical module junction box transfer device (E-JBTD) according to an exemplary embodiment of the invention;
FIG. 3A illustrates a schematic left side view of an electrical module junction box transfer device (E-JBTD) connected with a homogeneous electricity-generating glass or plastic device (TEGD) according to an exemplary embodiment of the invention;
FIG. 3B illustrates a schematic front side view of an electrical module junction box transfer device (E-JBTD) connected with a homogeneous electricity-generating glass or plastic device (TEGD) according to an exemplary embodiment of the invention;
FIG. 4 illustrates the bottom view of a homogeneous transparent electricity-generating device (TEGD) system including the electrical module junction box transfer device (E-JBTD) according to an exemplary embodiment of the invention;
FIG. 5A illustrates a schematic bottom view of a greenhouse electricity-generating system according to an exemplary embodiment of the invention; and
FIG. 5B illustrates a side view of a greenhouse electricity-generating system according to the exemplary embodiment of FIG. 5A.

### DETAILED DESCRIPTION OF THE EXEMPLARY EMBODIMENTS OF THE INVENTION

The present invention now is described more fully hereinafter with reference to the accompanying drawings, in which embodiments of the invention are shown. This invention, however, may be embodied in many different forms and should not be construed as limited to the embodiments set forth herein; rather, these embodiments are provided so that this disclosure will be thorough and complete, and will fully convey the scope of the invention to those skilled in the art.

Referring now to the drawings, exemplary embodiments of a homogeneous transparent electricity-generating device (TEGD) and electrical module junction box transfer device (E-JBTD) will now be described.

For background and purposes of comparison, FIG. 1A illustrates an example of a conventional MC-4 connector that is configured to fasten and connect an electricity-generating glass or plastic device (EGD) outside rated insulated conductor to a module or other device. As explained, such MC-4 connections are single-contact electrical connectors commonly used for connecting solar panels and the typical industry standard with regard to module-to-module, or module-to-balance of systems (BOS) terminal wire connections. FIG. 1B illustrates an example of a conventional c-Si (Black Body) photovoltaic (PV) module and FIG. 1C illustrates an example of a conventional transparent lane coated photovoltaic (PV) module.

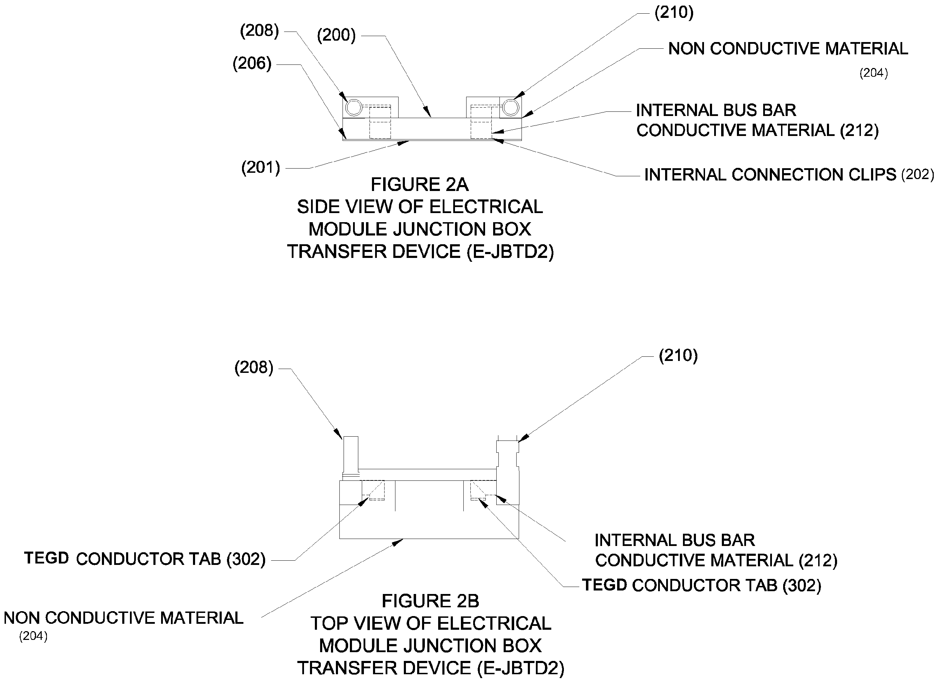

FIGS. 2A - 5B illustrate exemplary embodiments of a system for a transparent greenhouse electrical generating module (GEGM) including an electrical module junction box transfer device (E-JBTD) 200 and a homogeneous transparent electricity-generating glass or plastic device (TEGD) 300 according to exemplary embodiments of the invention.

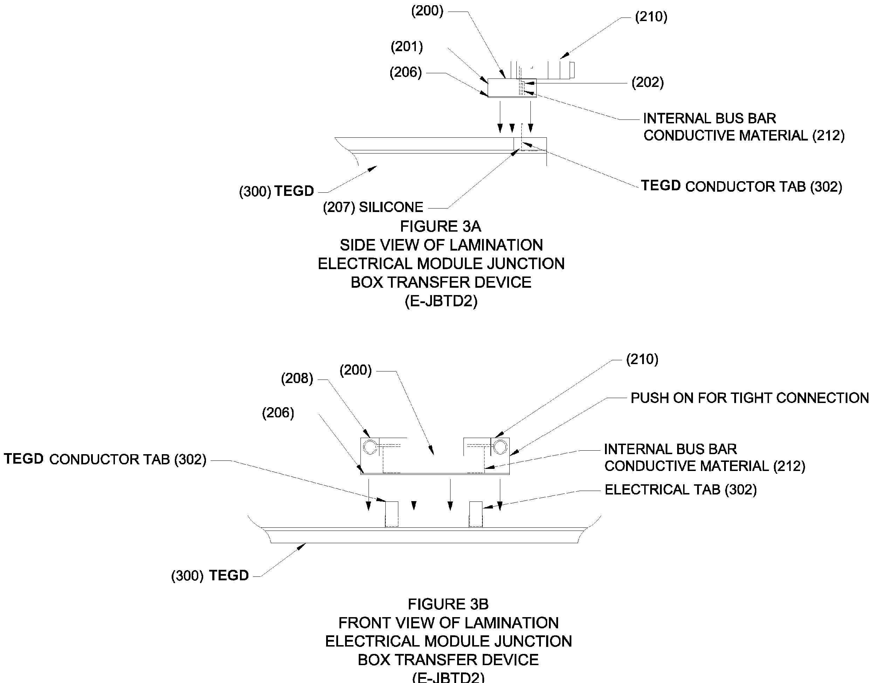

Particularly, FIGS. 2A - 2B illustrate a side and top view of an example of an electrical module junction box transfer device (E-JBTD) 200. As shown in the front side (FIG. 2A) of the electrical module junction box transfer device (E-JBTD) 200, the electrical module junction box transfer device (E-JBTD) 200 can have a body 201 including internal connection clips 202 (e.g., electron transfer clips; CLIP A 202 in FIGS. 3A, 3B) that are configured to be pressed on to the electrical tabs (e.g., TAB A 302 in FIGS. 3A, 3B) emerging from the front leading edge of the homogeneous transparent electricity-generating glass or plastic device (TEGD) 300. The electron transfer clips (CLIP A 202) are connected internally within the body 201 to the outside integrated MC-4 connectors 208, 210 that will allow for seamless connection to the universally used electrical connectors (e.g., electrical connectors commonly used for connecting solar panels in compliance with typical industry standards with regard to module to module, or module to balance of systems (BOS) terminal wire connections). The electrical module junction box transfer device (E-JBTD) 200 can include a non-conductive dielectric insulating material 204 that isolates the electrical contact points between the positive and negative conductor terminals to prevent arcing. For example, the non-conductive dielectric insulating material 204 can be a separate component provided to isolate the electrical contact points between the positive and negative conductor terminals to prevent arcing, or the non-conductive dielectric insulating material 204 can be integrally formed with the body 201, or a portion thereof, to isolate the electrical contact points between the positive and negative conductor terminals to prevent arcing. In an example, a leading edge of the body 201 of the electrical module junction box transfer device (E-JBTD) 200 can be capped with an insulating silicone material 206 and 207, or the like, allowing for a liquid-tight connection. Additionally, the top view (FIG. 2B) of the electrical module junction box transfer device (E-JBTD) 200 illustrates an example in which the electrical conductor points of contact are completely encased in non-conductive dielectric insulating material 204. Also, the top view illustrates an example of an internal bus bar 212 or the like, that is encapsulated with a non-conductive dielectric material 204 and runs from the internal clip 202 to the output wire connections (e.g., 208, 210). The MC-4 male 208 and female 210 connections are connections typically used to secure the output of positive and negative conductor terminal connections. In industry, the female connector 210 is typically positive (+) and the male connector 208 is typically negative (-). This plug and socket connection is designed to prevent accidental conductor connections.

FIGS. 3A - 3B illustrate exemplary side and front views of an electrical module junction box transfer device (E-JBTD) 200 as it fits onto a laminated homogeneous transparent electricity-generating glass or plastic device (TEGD) or module 300. FIGS. 3A - 3B illustrate examples of both the side and front views and how the electrical tab 302 extending from the EGP device/module 300 connects seamlessly to the electrical connector clip 202 of the E-JBTD 200. Also, FIGS. 3A - 3B illustrate examples including a silicone insulating, watertight seal 206 and 207 that fit between the E-JBTD 200 and the glass/glass or plastic/plastic laminate of the TEGD or module 300 (e.g., between the body 201, or a portion thereof, of the E-JBTD 200 and the glass/glass or plastic/plastic laminate of the TEGD or module 300).

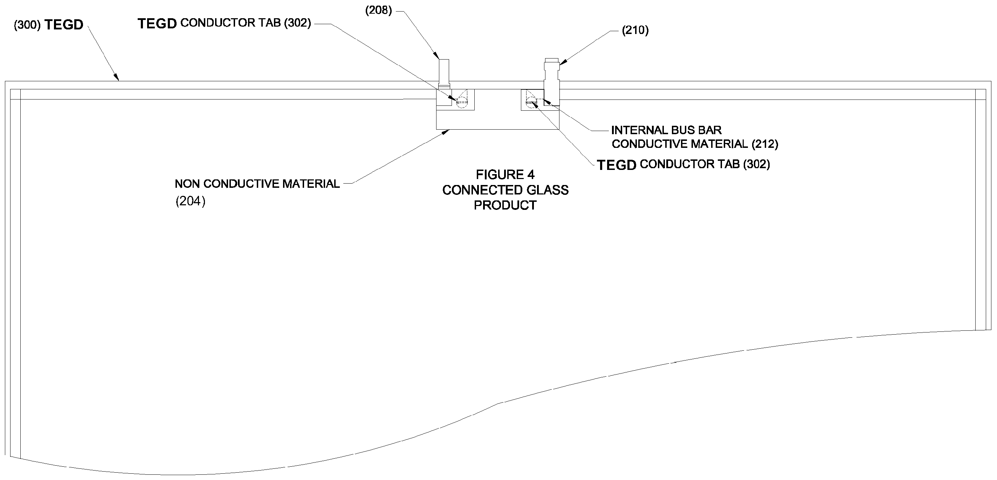

FIGS. 4 illustrates a top-down view of the homogeneous transparent electricity-generating glass or plastic device (TEGD) with an electrical module junction box transfer device (E-JBTD) 200 connected. FIG. 4 illustrates an example of a fully connected electrical module junction box transfer device (E-JBTD) 200 on an TEGD or module 300. In the illustrated examples, the size of the homogeneous transparent electricity-generating glass or plastic device (TEGD) is based upon the typical art used today for mounting greenhouse glass or plastic. The size, however, is not limited to the size shown in this example, and other examples can be configured differently with different sizing. For example, the size of the homogeneous transparent electricity-generating glass or plastic device (TEGD) 300 can be reduced or enlarged based upon the design of the greenhouse opening. FIG. 3B illustrates an example in which the fixture connection of the (E-JBTD) 200 can be configured to be secured with one click (i.e., a single click connection) to the TEGD or module 300. The electrical module junction box transfer device (E-JBTD) 200 can be configured to be easily applied to the module or homogeneous electricity-generating glass or plastic device (TEGD) 300 allowing for a safe and secure connection. In an example, once a connection between the electrical module junction box transfer devices (E-JBTD) 200 is made with the homogeneous electricity-generating glass or plastic device (TEGD) 300, it is not to be removed and reinstalled on another module or transparent electricity-generating glass or plastic device (TEGD) 300. In some examples, the electrical module junction box transfer device (E-JBTD) 200 can be such that it is not reusable, and is not intended to be removed (e.g., is not capable of being removed) once installed at the factory.

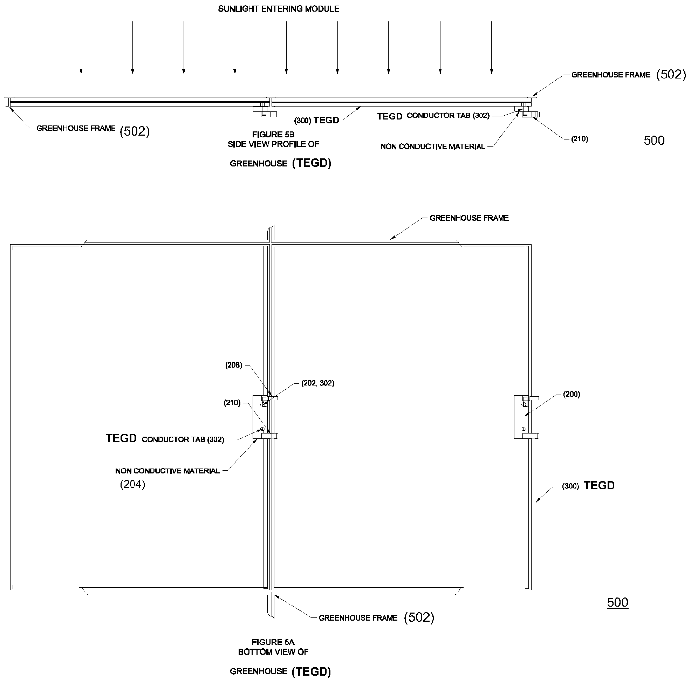

FIGS. 5A and 5B illustrate an example of a greenhouse electricity-generating system 500 according to an embodiment of the invention. As shown in FIGS. 5A and 5B, a portion of a greenhouse can include a module having a frame 502 (i.e., a greenhouse frame) supporting one or more homogeneous transparent panels permitting sunlight to enter or pass through the module into an interior of the greenhouse. One of ordinary skill in the art will recognize that other configurations of a greenhouse or a greenhouse module can be provided. The embodiments of the invention are not limited to any particular type of greenhouse arrangement or configuration.

The exemplary greenhouse electricity-generating system can include a homogeneous coated transparent electricity-generating glass or plastic device (TEGD) 300 and an electrical junction box transfer device (E-JBTD) 200. The homogeneous coated transparent electricity-generating glass or plastic device (TEGD) 300 can permit transmission of light into the greenhouse and onto plants within the greenhouse. In contrast with conventional transparent c-Si (Black Body) photovoltaic (PV) modules, for example, as shown in FIG. 1B and conventional transparent photovoltaic (PV) modules with lane coated lines, for example as shown in FIG. 1C, the exemplary embodiments of the invention can permit a larger amount of light to pass through the system, as well as a homogeneous transmission of light through the system, thereby enabling transmission of sufficient amounts of even and uniform homogeneous light for proper or desired plant growth.

Similar to the example embodiments described with reference to FIGS. 2A - 4, the electrical junction box transfer device (E-JBTD) 200 in the example of FIGS. 5A and 5B can include a body, one or more electrical connectors on the body, and a non-conductive dielectric insulating material protecting the one or more electrical connectors. As shown in FIGS. 5A and 5B, the exemplary electrical junction box transfer device (E-JBTD) 200 can be located on the homogeneous transparent electricity-generating glass or plastic device (TEGD) 300 such that interference or obstruction of light transmission through the coatings into the interior of the greenhouse can be prevented or minimized, thereby resulting in a larger amount of light and transmission of light into the greenhouse and onto plants within the greenhouse to improve, even and efficient growth of such plants, while at the same time providing desired amounts of electricity generation.

The present invention has been described herein in terms of several preferred embodiments. However, modifications and additions to these embodiments will become apparent to those of ordinary skill in the art upon a reading of the foregoing description. It is intended that all such modifications and additions comprise a part of the present invention to the extent that they fall within the scope of the several claims appended hereto.

## Claims

1. A system comprising:
an organic photovoltaic homogeneous coated electrical generating laminated device (300) including a double laminated coated electrical device; and
an electrical module junction box transfer device (200) integrated into an edge of the organic photovoltaic homogeneous coated electrical generating laminated device, the electrical module junction box transfer device (200) including:
a body (201);
one or more electrical connectors (208, 210) on the body wherein the one or more electrical connectors (208, 210) include at least one connection clip (202) internally within the body (201); and
an internal bus bar (212), which runs from the connection clip (202) to the one or more output electrical connectors (208, 210), wherein the internal bus bar (212) is encapsulated with a non-conductive dielectric insulating material (204) and the non-conductive dielectric insulating material (204) encases the one or more electrical connectors (208, 210).

2. The system of claim 1, wherein the organic photovoltaic homogeneous coated electrical generating laminated device (300) includes one low iron lite coated with a homogeneous organic photovoltaic coating and laminated between one or more lites utilizing a laminate film.

3. The system of claim 1, wherein the organic photovoltaic homogeneous coated electrical generating laminated device (300) further comprises:
two electrical bus bars (212) contained between two lites of laminated glass or plastic egressing out of two openings in a bottom lite of glass or plastic.

4. The system of claim 1, wherein the organic photovoltaic (OPV) homogeneous coated electrical generating laminated device further comprises:
a glass or plastic portion having two drilled holes and capped with an insulating material (206, 207) that is configured to provide a liquid-tight connection.

5. The system of claim 1, wherein the one or more electrical connectors (208, 210) of the electrical module junction box transfer device (200) includes at least two electrical connectors (208, 210), and
wherein the non-conductive dielectric insulating material (204) physically separates the at least two electrical conductor connectors (208, 210).

6. The system of claim 1, wherein the electrical module junction box transfer device (200) further comprises:
one or more single-contact electrical conductor connectors electrically connected to the one or more electrical connectors.

7. The system of claim 6, wherein the one or more single-contact electrical conductor connectors includes an MC-4 connection.

8. The system of claim 5, further comprising at least two single-contact electrical connectors electrically connected to the at least two electrical connectors, wherein the at least two single-contact electrical conductor connectors include MC-4 connections.

9. The system of claim 8, wherein one of the MC-4 connections includes a male MC-4 connection (208) and another of the MC-4 connections includes a female MC-4 connection (210).

10. The system of claim 1, wherein an edge of the body of the electrical module junction box transfer device (200) is capped with an insulating material that is configured to provide a liquid-tight connection to the organic photovoltaic homogeneous coated electrical generating laminated device.

11. The system of claim 1, wherein the one or more electrical connectors (208, 210) are completely isolated from each other by the non-conductive dielectric insulating material (204).

12. The system of claim 6, further comprising:
an internal bus-bar (212) electrically connecting the one or more single-contact electrical connectors to the one or more electrical connectors and encapsulated within the non-conductive dielectric insulating material (204).

13. A greenhouse electricity-generating system comprising:
the organic photovoltaic homogeneous coated electrical generating laminated device (300) and the electrical module junction box transfer device (200) of claim 1,
wherein the electrical module junction box transfer device (200) is on the organic photovoltaic homogeneous coated electrical generating laminated device (300).

14. The system of claim 13, further comprising:
an insulating material between the organic photovoltaic homogeneous coated electrical generating laminated device and the electrical module junction box transfer device and configured to provide a liquid-tight connection between the organic photovoltaic homogeneous coated electrical generating laminated device and electrical module junction box transfer device.

## Patentansprüche

1. Ein System, das Folgendes beinhaltet:
eine organische, photovoltaische, homogen beschichtete, stromerzeugende, laminierte Vorrichtung (300), die eine doppelt laminierte, beschichtete elektrische Vorrichtung umfasst; und
eine elektrische Modulanschlusskastentransfervorrichtung (200), die in eine Kante der organischen, photovoltaischen, homogen beschichteten, stromerzeugenden,
laminierten Vorrichtung integriert ist, wobei die elektrische
Modulanschlusskastentransfervorrichtung (200) Folgendes umfasst:
einen Körper (201);
einen oder mehrere elektrische Verbinder (208, 210) auf dem Körper, wobei der eine oder die mehreren elektrischen Verbinder (208, 210) wenigstens eine Verbindungsklemme (202) im Inneren des Körpers (201) umfassen; und
eine interne Stromschiene (212), die von der Verbindungsklemme (202) zu dem einen oder den mehreren elektrischen Ausgangsverbindern (208, 210) verläuft, wobei die interne Stromschiene (212) mit einem nichtleitenden, dielektrischen Isoliermaterial (204) eingekapselt ist und das nichtleitende, dielektrische Isoliermaterial (204) den einen oder die mehreren elektrischen Verbinder (208, 210) umschließt.

2. System gemäß Anspruch 1, wobei die organische, photovoltaische, homogen beschichtete, stromerzeugende, laminierte Vorrichtung (300) eine eisenarme Scheibe umfasst, die mit einer homogenen, organischen, photovoltaischen Beschichtung beschichtet ist und zwischen einer oder mehreren Scheiben unter Nutzung einer Laminatfolie laminiert ist.

3. System gemäß Anspruch 1, wobei die organische, photovoltaische, homogen beschichtete, stromerzeugende, laminierte Vorrichtung (300) ferner Folgendes beinhaltet:
zwei elektrische Stromschienen (212), die zwischen zwei Scheiben aus Verbundglas oder laminiertem Kunststoff, die aus zwei Öffnungen in einer unteren Scheibe aus Glas oder Kunststoff austreten, enthalten sind.

4. System gemäß Anspruch 1, wobei die organische, photovoltaische (OPV), homogen beschichtete, stromerzeugende, laminierte Vorrichtung ferner Folgendes beinhaltet:
einen Abschnitt aus Glas oder Kunststoff, der zwei Bohrungen aufweist und mit einem Isoliermaterial (206, 207) abgedeckt ist, das dazu konfiguriert ist, eine flüssigkeitsdichte Verbindung bereitzustellen.

5. System gemäß Anspruch 1, wobei der eine oder die mehreren elektrischen Verbinder (208, 210) der elektrischen Modulanschlusskastentransfervorrichtung (200) wenigstens zwei elektrische Verbinder (208, 210) umfassen(,) und
wobei das nichtleitende, dielektrische Isoliermaterial (204) die wenigstens zwei elektrischen Leiterverbinder (208, 210) physisch trennt.

6. System gemäß Anspruch 1, wobei die elektrische Modulanschlusskastentransfervorrichtung (200) ferner Folgendes beinhaltet:
einen oder mehrere elektrische Einzelkontaktleiterverbinder, die mit dem einen oder den mehreren elektrischen Verbindern elektrisch verbunden sind.

7. System gemäß Anspruch 6, wobei der eine oder die mehreren elektrischen Einzelkontaktleiterverbinder eine MC-4-Verbindung umfassen.

8. System gemäß Anspruch 5, das ferner wenigstens zwei elektrische Einzelkontaktverbinder beinhaltet, die mit den wenigstens zwei elektrischen Verbindern elektrisch verbunden sind, wobei die wenigstens zwei elektrischen Einzelkontaktleiterverbinder MC-4-Verbindungen umfassen.

9. System gemäß Anspruch 8, wobei eine der MC-4-Verbindungen eine MC-4-Steckerverbindung (208) umfasst und eine andere der MC-4-Verbindungen eine MC-4-Buchsenverbindung (210) umfasst.

10. System gemäß Anspruch 1, wobei eine Kante des Körpers der elektrischen Modulanschlusskastentransfervorrichtung (200) mit einem Isoliermaterial abgedeckt ist, das dazu konfiguriert ist, eine flüssigkeitsdichte Verbindung mit der organischen, photovoltaischen, homogen beschichteten, stromerzeugenden, laminierten Vorrichtung bereitzustellen.

11. System gemäß Anspruch 1, wobei der eine oder die mehreren elektrischen Verbinder (208, 210) durch das nichtleitende, dielektrische Isoliermaterial (204) vollständig voneinander isoliert sind.

12. System gemäß Anspruch 6, das ferner Folgendes beinhaltet:
eine interne Stromschiene (212), die den einen oder die mehreren elektrischen Einzelkontaktverbinder mit dem einen oder den mehreren elektrischen Verbindern elektrisch verbindet und in dem nichtleitenden, dielektrischen Isoliermaterial (204) eingekapselt ist.

13. Ein Gewächshauselektrizitätserzeugungssystem, das Folgendes beinhaltet:
die organische, photovoltaische, homogen beschichtete, stromerzeugende, laminierte Vorrichtung (300) und die elektrische Modulanschlusskastentransfervorrichtung (200) nach Anspruch 1,
wobei sich die elektrische Modulanschlusskastentransfervorrichtung (200) auf der organischen, photovoltaischen, homogen beschichteten, stromerzeugenden,
laminierten Vorrichtung (300) befindet.

14. System gemäß Anspruch 13, das ferner Folgendes beinhaltet:
ein Isoliermaterial zwischen der organischen, photovoltaischen, homogen beschichteten, stromerzeugenden, laminierten Vorrichtung und der elektrischen Modulanschlusskastentransfervorrichtung, das dazu konfiguriert ist, eine flüssigkeitsdichte Verbindung zwischen der organischen, photovoltaischen, homogen beschichteten, stromerzeugenden, laminierten Vorrichtung und der elektrischen Modulanschlusskastentransfervorrichtung bereitzustellen.

## Revendications

1. Un système comprenant :
un dispositif stratifié de génération électrique à revêtement homogène photovoltaïque organique (300) incluant un dispositif électrique à revêtement stratifié double ; et
un dispositif de transfert de boîte de jonction de module électrique (200) intégré dans un bord du dispositif stratifié de génération électrique à revêtement homogène photovoltaïque organique, le dispositif de transfert de boite de jonction de module électrique (200) incluant :
un corps (201) ;
un ou plusieurs connecteurs électriques (208, 210) sur le corps, les un ou plusieurs connecteurs électriques (208, 210) incluant au moins un clip de connexion (202) en interne à l'intérieur du corps (201) ; et
une barre omnibus interne (212), qui va du clip de connexion (202) aux un ou plusieurs connecteurs électriques (208, 210) de sortie, la barre omnibus interne (212) étant encapsulée avec un matériau isolant diélectrique non conducteur (204) et le matériau isolant diélectrique non conducteur (204) enrobant les un ou plusieurs connecteurs électriques (208, 210).

2. Le système de la revendication 1, où le dispositif stratifié de génération électrique à revêtement homogène photovoltaïque organique (300) inclut un panneau à faible teneur en fer revêtu d'un revêtement photovoltaïque organique homogène et stratifié entre un ou plusieurs panneaux en utilisant un film stratifié.

3. Le système de la revendication 1, où le dispositif stratifié de génération électrique à revêtement homogène photovoltaïque organique (300) comprend en outre :
deux barres omnibus électriques (212) contenues entre deux panneaux de verre ou de plastique stratifié émergeant de deux ouvertures dans un panneau inférieur de verre ou de plastique.

4. Le système de la revendication 1, où le dispositif stratifié de génération électrique à revêtement homogène photovoltaïque organique (PVO) comprend en outre :
une portion en verre ou en plastique présentant deux trous percés et coiffée d'un matériau isolant (206, 207) qui est configuré pour fournir une connexion étanche aux liquides.

5. Le système de la revendication 1, où les un ou plusieurs connecteurs électriques (208, 210) du dispositif de transfert de boîte de jonction de module électrique (200) incluent au moins deux connecteurs électriques (208, 210), et
où le matériau isolant diélectrique non conducteur (204) sépare physiquement les au moins deux connecteurs à conducteur électrique (208, 210).

6. Le système de la revendication 1, où le dispositif de transfert de boîte de jonction de module électrique (200) comprend en outre :
un ou plusieurs connecteurs à conducteur électrique à contact unique connectés électriquement aux un ou plusieurs connecteurs électriques.

7. Le système de la revendication 6, où les un ou plusieurs connecteurs à conducteur électrique à contact unique incluent une connexion MC-4.

8. Le système de la revendication 5, comprenant en outre au moins deux connecteurs électriques à contact unique connectés électriquement aux au moins deux connecteurs électriques, les au moins deux connecteurs à conducteur électrique à contact unique incluant des connexions MC-4.

9. Le système de la revendication 8, où une des connexions MC-4 inclut une connexion MC-4 mâle (208) et une autre des connexions MC-4 inclut une connexion MC-4 femelle (210).

10. Le système de la revendication 1, où un bord du corps du dispositif de transfert de boîte de jonction de module électrique (200) est coiffé d'un matériau isolant qui est configuré pour fournir une connexion étanche aux liquides au dispositif stratifié de génération électrique à revêtement homogène photovoltaïque organique.

11. Le système de la revendication 1, où les un ou plusieurs connecteurs électriques (208, 210) sont complètement isolés l'un de l'autre par le matériau isolant diélectrique non conducteur (204).

12. Le système de la revendication 6, comprenant en outre :
une barre omnibus interne (212) connectant électriquement les un ou plusieurs connecteurs électriques à contact unique aux un ou plusieurs connecteurs électriques et encapsulée à l'intérieur du matériau isolant diélectrique non conducteur (204).

13. Un système de génération d'électricité de serre comprenant :
le dispositif stratifié de génération électrique à revêtement homogène photovoltaïque organique (300) et le dispositif de transfert de boîte de jonction de module électrique (200) de la revendication 1,
où le dispositif de transfert de boîte de jonction de module électrique (200) est sur le dispositif stratifié de génération électrique à revêtement homogène photovoltaïque organique (300).

14. Le système de la revendication 13, comprenant en outre :
un matériau isolant entre le dispositif stratifié de génération électrique à revêtement homogène photovoltaïque organique et le dispositif de transfert de boîte de jonction de module électrique et configuré pour fournir une connexion étanche aux liquides entre le dispositif stratifié de génération électrique à revêtement homogène photovoltaïque organique et le dispositif de transfert de boîte de jonction de module électrique.
